# EUROPÄISCHE PATENTSCHRIFT

(11) **EP 3 679 644 B1**
(45) Veröffentlichungstag und Bekanntmachung des Hinweises auf die Patenterteilung: **01.09.2021**
(21) Anmeldenummer: 18765705.1
(22) Anmeldetag: 30.07.2018
(51) Int. Cl.: H02M 1/15, H02M 1/32, H03G 1/00, G01R 31/333, H03B 11/02, H03K 3/537

(54) **SCHALTUNG UND VERFAHREN ZUR DÄMPFUNG VON VERSORGUNGSSPANNUNGS-INDUZIERTEN SCHWINGUNGEN IM EINGANGSKREIS EINES GLEICHSPANNUNGSWANDLERS**
CIRCUIT AND METHOD FOR ATTENUATING SUPPLY-VOLTAGE-INDUCED OSCILLATIONS IN THE INPUT CIRCUIT OF A DC POWER CONVERTER
CIRCUIT ET PROCÉDÉ POUR ATTÉNUER DES OSCILLATIONS INDUITES PAR LA TENSION D'ALIMENTATION DANS LE CIRCUIT D'ENTRÉE D'UN CONVERTISSEUR DE COURANT CONTINU

(30) Priorität: 08.09.2017 DE 202017004715 U
(43) Veröffentlichungstag der Anmeldung: 15.07.2020
(73) Patentinhaber: WAGO Verwaltungsgesellschaft mit beschränkter Haftung, 32423 Minden (DE)
(72) Erfinder: BINDSEIL, Walter, 33605 Bielefeld (DE)
(74) Vertreter: Müller, Wolf-Christian
(86) Internationale Anmeldenummer: PCT/IB2018/000816
(87) Internationale Veröffentlichungsnummer: WO 2019/048919

(56) Entgegenhaltungen:
- WO-A1-2011/085703
- DE-A1-102010 017 303
- US-A- 6 097 158
- US-A1- 2006 214 599
- US-A1- 2012 313 428

## Beschreibung

### GEBIET

Die vorliegende Erfindung bezieht sich auf eine Schaltung und ein Verfahren zur Dämpfung/Vermeidung von Versorgungsspannungs-induzierten Schwingungen in einem Eingangskreis eines Gleichspannungswandlers während einer Stoßspannungs-Robustheitsprüfung

### HINTERGRUND

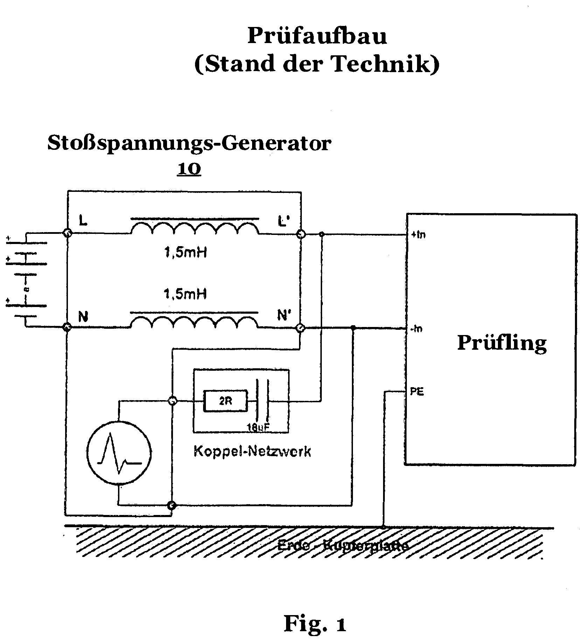

Die DIN EN 61000-4-5 fordert eine Prüfung und den Beweis der Robustheit elektrischer Geräte gegen Stoßspannungen (Surge) aus dem versorgenden Netz. In Fig. 1 ist dazu das Schaltbild eines beispielhaften Prüfaufbaus (gemäß dem Stand der Technik) für Stoßspannungsprüfungen dargestellt. Die erzeugten Stoßspannungsamplituden liegen dabei typischerweise zwischen 0,5 kV und 6 kV.

Der für die Prüfung verwendete Surge-Generator weist interne Entkoppelungsinduktivitäten auf, die dem Schutz der Prüfeinrichtung dienen und dafür sorgen, dass die Stoßspannungsenergie in Richtung Prüfling (DUT, "device under test") konzentriert wird. In Verbindung mit dem negativen differenziellen Eingangswiderstand und der Eingangskapazität eines Gleichspannungswandlers können dadurch Schwingungen angeregt werden, die die Prüfung erschweren bzw. den Prüfling während der Prüfung beschädigen.

Die Druckschriften WO2011085703, US2012313428, US2006214599 und US6097158 schlagen vor, den Strom in einer Zuleitung durch FETs oder MOSFETs als variable und gesteuerte Impedanzen zu begrenzen. DE102010017303 beschreibt ein Stoßspannungsprüfsystem mit einer Korrekturfunktion zur Reduzierung von systematischen Messfehlern.

### ZUSAMMENFASSUNG

Die Erfindung bereichert diesbezüglich den Stand der Technik, als erfindungsgemäße Schaltungen einen Eingangskreis umfassen, welcher bei der Prüfung entstehende Schwingungen hinreichend dämpft, indem der Widerstand eines im Eingangskreis angeordneten Halbleiterelements beim Auftreten von Spannungsschwankungen temporär erhöht wird.

Bspw. kann die spannungsabhängige Abschnüreigenschaft eines Verpolungsschutz-Metall-Oxid-Halbleiter-Feldeffekttransistors (Verpolungsschutz-MOSFETs) genutzt werden, indem der Durchgangswiderstand des MOSFETs während einer Aufschwingphase temporär so erhöht wird, dass der Schwingkreis (bestehend aus Entkoppelungsinduktivitäten des Surge-Generators, Eingangskapazität und negativem Eingangswiderstand des Gleichspannungswandlers) bedämpft wird. Das Maß der Dämpfung kann zudem durch das Hinzufügen von Widerständen und Kondensatoren an die zu erwartende Schwingungsamplitude und an die zu erwartende Frequenz angepasst werden.

Damit ist eine Prüfung nach DIN EN 61000-4-5 möglich, ohne den Testaufbau wesentlich zu ändern und ohne einen Eingriff bzw. eine Veränderung des Produkts vornehmen und insbesondere ohne Einschränkungen hinsichtlich der Betriebsbedingungen hinnehmen zu müssen.

Die Erfindung wird durch die Merkmale der unabhängigen Ansprüche 1, 5 und 7 festgelegt. Die abhängigen Ansprüche definieren bevorzugte Ausgestaltungen der Erfindung.

Eine erfindungsgemäße Schaltung umfasst einen Gleichspannungswandler und einen dem Gleichspannungswandler vorgeschalteten Eingangskreis, welcher einen ersten Anschluss und einen zweiten Anschluss zum Anschluss an eine Spannungsversorgung und einen dritten Anschluss und einen vierten Anschluss zum Anschluss an den Gleichspannungswandler aufweist.

Der Eingangskreis weist zwischen dem ersten und dritten Anschluss ein Halbleiterelement auf, wobei ein erster Bauelemente-Anschluss des Halbleiterelements zumindest über einen ersten Kondensator und einen zweiten Kondensator an einen zweiten Bauelemente-Anschluss des Halbleiterelements angeschlossen ist und ein Widerstand des Halbleiterelements über eine Spannung zwischen dem ersten Bauelemente-Anschluss und dem zweiten Bauelemente-Anschluss steuerbar ist.

Dabei ist unter dem Begriff "Halbleiterelement", wie er in der Beschreibung und den Ansprüchen verwendet wird, insbesondere ein elektronisches Bauelement zu verstehen, welches zumindest teilweise aus Halbleitermaterial hergestellt ist. Ferner ist unter dem Begriff "Gleichspannungswandler", wie er in der Beschreibung und den Ansprüchen verwendet wird, insbesondere eine Schaltung zu verstehen, die eine zugeführte Gleichspannung in eine Gleichspannung mit höherem, niedrigerem oder invertiertem Spannungsniveau umwandelt.

Vorzugsweise ist das Halbleiterelement als Feldeffekttransistor, FET, und vorzugsweise als Verpolungsschutz-Halbleiterschalter ausgebildet.

Dabei ist unter dem Begriff "Verpolungsschutz-Halbleiterschalter", wie er in der Beschreibung und den Ansprüchen verwendet wird, insbesondere ein Halbleiterelement zu verstehen, welches bei Anlegen einer elektrischen Spannung falscher Polarität an die Schaltung den Stromkreis unterbricht.

Vorzugsweise ist ein Gate-Anschluss des FETs an einen ersten Bauelemente-Anschluss des ersten Kondensators angeschlossen und über einen Widerstand einer zum ersten Kondensator parallel geschalteten Spannungsteilerschaltung mit dem Source-Anschluss des FETs verbunden, sind ein zweiter Bauelemente-Anschluss des ersten Kondensators und ein zweiter Bauelemente-Anschluss eines zweiten Kondensators an dem zweiten Anschluss angeschlossen und ist ein Source-Anschluss des FETs an einen ersten Bauelemente-Anschluss des zweiten Kondensators angeschlossen..

Vorzugsweise ist der FET als Metall-Oxid-Halbleiter-Feldeffekttransistor, MOSFET, ausgebildet.

Vorzugsweise ist der erste Anschluss an einem ersten Pol des Stoßspannungs-Generators und der zweite Anschluss an einem zweiten Pol des Stoßspannungs-Generators, welcher Entkopplungs-Induktivitäten aufweist, angeschlossen.

Vorzugsweise sind der erste und zweite Kondensator ausgebildet, eine durch Anlegen einer Spannung an den Gleichspannungswandler erzeugte Schwingung in einem die Entkopplungs-Induktivitäten umfassenden Schwingkreis durch spannungsschwankungsabhängiges Erhöhen eines Widerstands des Halbleiterelements zu dämpfen, wobei die Dämpfung ausgelegt ist, eine Unterspannungsabschaltung des Gleichspannungswandlers und/oder eine Überlast an einer Eingangsschutzdiode zu vermeiden.

Ein erfindungsgemäßes Verfahren zur Prüfung einer Schaltung auf Robustheit gegen Stoßspannungen umfasst ein Anlegen einer Spannung an einen Eingangskreis der Schaltung, wobei der Eingangskreis ein Halbleiterelement aufweist, und ein Dämpfen einer durch das Anlegen der Spannung im Eingangskreis erzeugten Schwingung, welche im Eingangskreis eine Spannungsschwankung verursacht, wobei das Dämpfen ein durch die Spannungsschwankung gesteuertes Erhöhen eines Widerstandes des Halbleiterelements umfasst.

Vorzugsweise ist das Halbleiterelement als Feldeffekttransistor, FET, und besonders vorzugsweise als Verpolungsschutz-Halbleiterschalter ausgebildet.

Vorzugsweise umfasst das durch die Spannungsschwankung gesteuerte Erhöhen des Widerstandes ein spannungsschwankungsabhängiges Reduzieren einer am FET anliegenden Gate-Source-Spannung, welches ein zeitliches Verzögern eines Abfallens eines Gate-Potenzials bewirkt.

Vorzugsweise ist ein Drain-Anschluss des FETs an einen ersten Pol einer Spannungsquelle angeschlossen und ein Gate-Anschluss des FETs über einen Kondensator mit einem zweiten Pol der Spannungsquelle verbunden, wobei das zeitliche Verzögern des Abfallens des Gate-Potenzials durch ein Aufladen/Entladen des Kondensators über einen Widerstand bewirkt wird.

### KURZBESCHREIBUNG DER ZEICHNUNGEN

Die Erfindung wird nachfolgend in der detaillierten Beschreibung anhand von Ausführungsbeispielen erläutert, wobei auf Zeichnungen Bezug genommen wird, in denen:
Fig. 1 ein Schaltbild eines beispielhaften Prüfaufbaus (gemäß dem Stand der Technik) für eine Stoßspannungsprüfung;
Fig. 2 ein Schaltbild eines einem Gleichspannungswandler vorschaltbaren Eingangskreises mit einem Verpolungsschutz und einem Filter für leitungsgebundene Störaussendung (gemäß dem Stand der Technik);
Fig. 3 während einer Stoßspannungsprüfung im Eingangskreis der Fig. 2 auftretende Schwingungen;
Fig. 4 einen einem Gleichspannungswandler vorschaltbaren Eingangskreis zur Dämpfung/Vermeidung der Schwingungen;
Fig. 5 während eines Robustheitstest im Eingangskreis der Fig. 4 und am Ausgang eines dem Eingangskreis nachgeschalteten Gleichspannungswandlers auftretende Spannungen;
Fig. 6 einen im Vergleich zu dem in Fig. 4 gezeigten Eingangskreis abgewandelten Eingangskreis;
Fig. 7 ein Flussdiagramm eines Verfahrens zur Robustheitsprüfung einer Schaltung, die einen Gleichspannungswandler aufweist, zeigt.

Dabei sind in den Zeichnungen gleiche oder funktional ähnliche Elemente durch gleiche Bezugszeichen gekennzeichnet.

### DETAILLIERTE BESCHREIBUNG

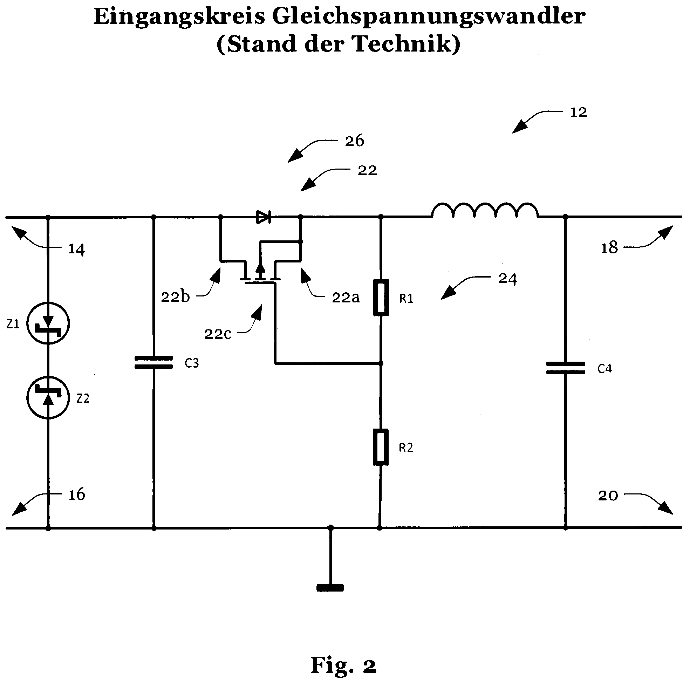

Fig. 2 illustriert schematisch eine mögliche Ausgestaltung eines Eingangskreises 12 eines Gleichspannungswandlers (nicht gezeigt). Der Eingangskreis 12 umfasst einen ersten Anschluss 14 und einen zweiten Anschluss 16 zum Anschluss an eine Spannungsversorgung (bspw. 24 V). Der Eingangskreis 12 umfasst ferner einen dritten Anschluss 18 und einen vierten Anschluss 20 zum Anschluss an den Gleichspannungswandler. Der erste Anschluss 14 ist über den Drain-Anschluss 22b und den Source-Anschluss 22a eines Halbleiterelements 22 (FET bzw. Verpolungsschutz-MOSFET) mit dem dritten Anschluss 18 verbunden.

Wie in Fig. 2 gezeigt, ist der Gate-Anschluss 22c über die Spannungsteilerschaltung 24 an den ersten Anschluss 14 und an den zweiten Anschluss 16 angeschlossen, so dass das Gate-Potenzial (im quasistationären Betrieb) zwischen dem Potenzial am ersten Anschluss 14 und dem Potenzial am zweiten Anschluss 16 (und somit zwischen dem Source-Potenzial und dem Ground-Potenzial) liegt. Ist die Spannungsdifferenz zwischen dem ersten Anschluss 14 und dem zweiten Anschluss 16 ausreichend hoch, wird der Kanal zwischen dem Source-Anschluss 22a und dem Drain-Anschluss 22b leitend. Bei falscher Polung des ersten Anschluss 14 und des zweiten Anschluss 16, wird der Stromfluss durch den Kanal und die Diode 26 hingegen unterbunden. Zudem ist zwischen dem ersten Anschluss 14 und dem zweiten Anschluss 16 zur Begrenzung der Eingangsspannung eine Eingangsschutzdiodenschaltung angeordnet, welche bspw., wie in Fig. 2 gezeigt, zwei antiseriell verschaltete Zenerdioden umfassen kann.

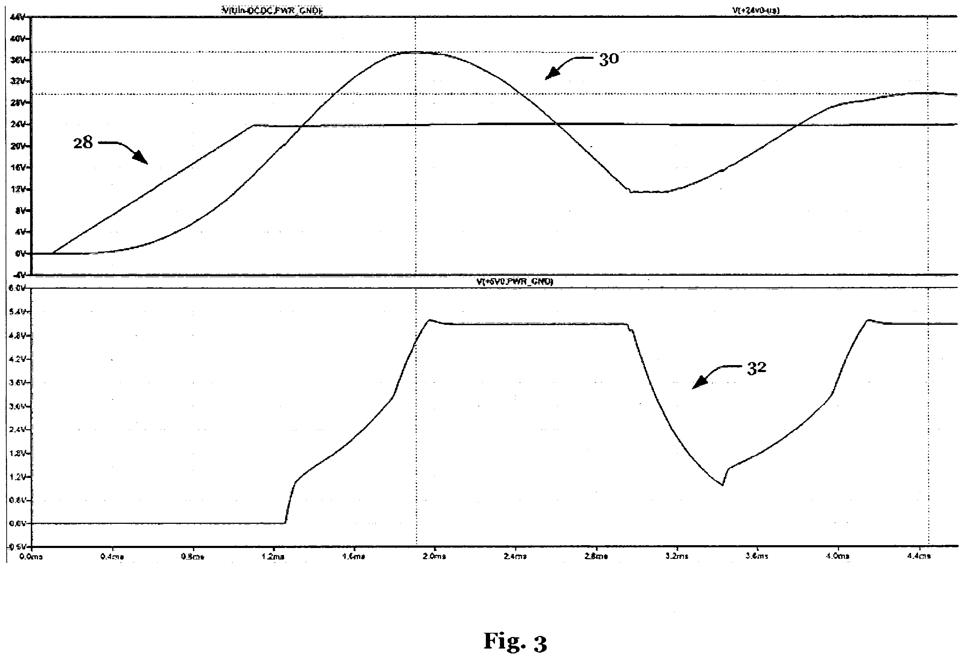

Fig.3 zeigt ein zu dem in Fig. 2 gezeigten Eingangskreis 12 und einem an den Eingangskreis 12 angeschlossenen Gleichspannungswandler (nicht gezeigt) passendes Anlaufverhalten bei Durchführung einer Stoßspannungsprüfung. Nach dem Einschalten der versorgenden Prüfspannung (Eingangsspannung des Eingangskreises 10) 28 taktet der Gleichspannungswandler ab einer Eingangsspannung 30 von 18 V die Ausgangsspannung 32 von o V auf 5 V hoch.

Aufgrund der Entkoppelungsinduktivitäten im Stoßspannungsgenerator 10, der Kapazitäten im Eingangskreis 12 und des negativen Eingangswiderstands des Gleichspannungswandlers ist ein Aufschwingen der Eingangsspannung 30 zu beobachten. In der negativen Halbwelle der Schwingungsamplitude fällt die Eingangsspannung 30 unter 12V und damit unter die Unterspannungsabschaltungsschwelle des Gleichspannungswandlers. In Folge dessen bricht die Ausgangsspannung 32 des Gleichspannungswandlers ein und die Prüfung kann nicht fortgesetzt werden.

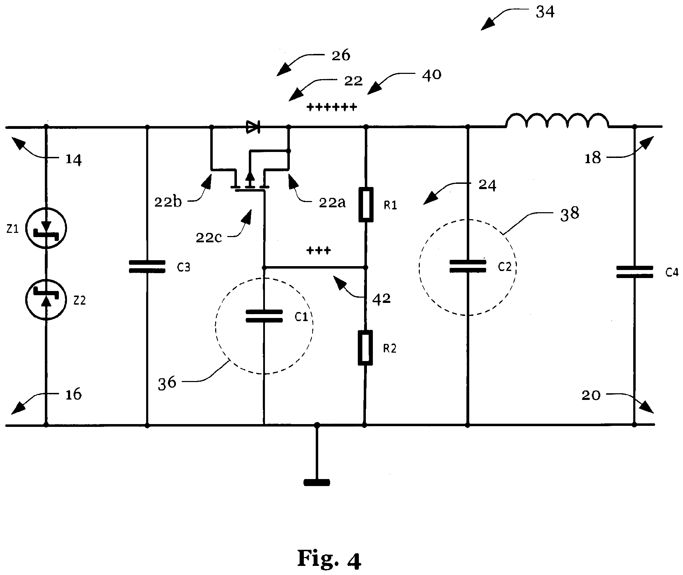

Ein modifizierter Eingangskreis 34 zur Dämpfung/Vermeidung solcher Schwingungen ist in Fig. 4 gezeigt. Der Eingangskreis 34 weist, wie der in Fig. 2 gezeigte Eingangskreis 12, einen ersten Anschluss 14 und einen zweiten Anschluss 16 zum Anschluss an eine Spannungsversorgung und einen dritten Anschluss 18 und einen vierten Anschluss 20 zum Anschluss an den Gleichspannungswandler (nicht gezeigt) auf.

Der erste Anschluss 14 ist, wie in Fig. 2, über den Drain-Anschluss 22b und den Source-Anschluss 22a eines Verpolungsschutz-MOSFETs 22 mit dem dritten Anschluss 18 verbunden. Ebenso ist der Gate-Anschluss 22c über die Spannungsteilerschaltung 24 an den ersten Anschluss 14 und an den zweiten Anschluss 16 angeschlossen, so dass das Gate-Potenzial 42 (im quasistationären Betrieb) zwischen dem Potenzial am ersten Anschluss 14 und dem Potenzial am zweiten Anschluss 16 (und somit zwischen dem Source-Potenzial 40 und dem Ground-Potenzial) liegt.

Jedoch ist der modifizierte Eingangskreis 34 im Vergleich zu dem in Fig. 2 gezeigten Eingangskreis 12 um zwei Kondensatoren erweitert, einen ersten Kondensator 36 zwischen dem Gate-Anschluss 22c und dem zweiten Anschluss 16 und einen zweiten Kondensator 38 zwischen dem Source-Anschluss 22a und dem zweiten Anschluss 16. Wie in Fig. 4 gezeigt, ist der Gate-Anschluss 22c des Verpolungsschutz-MOSFETs 22 somit über den ersten Kondensator 36 und den zweiten Kondensator 38 mit dem Source-Anschluss 22a des Verpolungsschutz-MOSFETs 22 verbunden. Dadurch wird über die Kondensatoren 36, 38 zwischen dem Source-Anschluss 22a und dem Gate-Anschluss 22c ein zusätzlicher "Entladepfad" erzeugt.

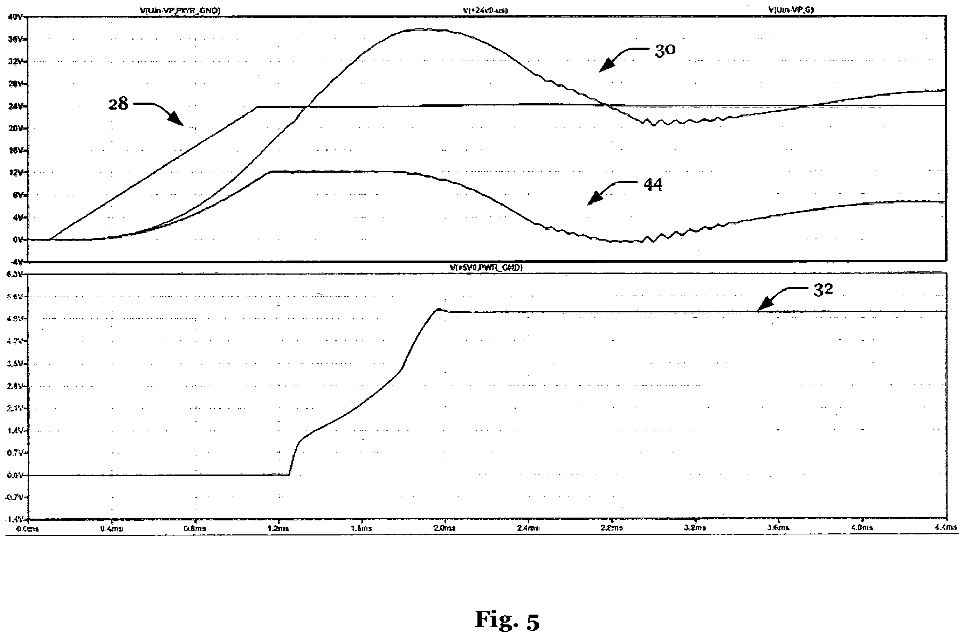

Wie in Fig. 5 gezeigt, sinkt beim Übergang der Schwingungsamplitude von der positiven in die negative Halbwelle das Source-Potenzial 40. Jedoch wird das ebenfalls sinkende Gate-Potenzial 42 durch den zu entladenden ersten Kondensator 36 gestützt, wodurch das Gate-Potenzial 42 in Vergleich zu dem in Fig. 2 gezeigten Eingangskreis 12 langsamer abfällt.

Anders ausgedrückt, wird der Spannungsabfall an dem Widerstand R2 der Spannungsteilerschaltung 24 durch die Zeitkonstante R1*C1 verzögert, wodurch der Spannungsabfall an R1 beschleunigt wird. Fällt z. B. die Eingangsspannung 30 innerhalb von einer Millisekunde um 5 V ab, "sieht" R2 in der gleichen Zeit einen Spannungsabfall von 1,8 V. Der Spannungsabfall an R1 beträgt dann: R1=5V-1,8V=3,2V.

Wenn die Source-Gate-Spannung ursprünglich 5V betrug, so beträgt sie durch das Sinken der Eingangsspannung 30 nur noch 5 V-3,2 V = 1,8 V. Dadurch ist die Drain-Source Strecke deutlich hochohmiger geworden. Beim Übergang der Schwingungsamplitude von der positiven in die negative Halbwelle fällt die Source-Gate-Spannung 44 des Verpolungsschutz-MOSFETs 22, wie in Fig. 5 gezeigt, somit annähernd mit der gleichen Steilheit wie die Eingangsspannung 30.

Dadurch wird die Source-Gate-Spannung reduziert und der Durchgangswiderstand des Verpolungsschutz-MOSFETs 22 zwischen dem Source-Anschluss 22a und dem Drain-Anschluss 22b erhöht. Durch das Erhöhen des Durchgangswiderstands des Verpolungsschutz-MOSFETs 22 wird der Abfall des Source-Potenzials gebremst, in Folge dessen sich die Source-Gate-Spannung 44 wieder stabilisiert.

Dies bewirkt, dass sich der Durchgangswiderstand wieder reduziert und das Source-Potenzial erneut fällt. In Fig. 5 ist dieses Verhalten an den welligen Abschnitten der Eingangsspannung 30 und der Source-Gate-Spannung 44 zu erkennen, die anzeigen, ab wann das Abschnürverhalten des Verpolungsschutz-MOSFETs 22 einsetzt (bzw. endet).

Der Durchgangswiderstand des Verpolungsschutz-MOSFETs 22 wirkt in diesem Bereich als ein Dämpfungswiderstand in dem LC-Schwingkreis. In dem in Fig. 5 gezeigten Beispiel reicht die Dämpfung dabei aus, um die negative Halbwelle der Eingangsspannung 30 über 20 V zu halten. Damit bleibt die Eingangsspannung 30 des Gleichspannungswandlers über der Unterspannungsabschaltungsschwelle von 12 V, und die Ausgangsspannung 32 des Gleichspannungswandler beträgt durchgängig 5 V.

Somit kann eine Unterspannungsabschaltung des Gleichspannungswandlers vermieden und die Prüfung fortgesetzt werden. Sobald die Schwingung wieder in die positive Halbwelle übergeht, wird die Source-Gate-Spannung 44 wieder aufgeladen und der Durchgangswiderstand des Verpolungsschutz-MOSFETs 22 fällt. Die Intensität der Dämpfung lässt sich somit über eine geeignete Dimensionierung der Widerstände der Spannungsteilerschaltung 24 und der Kondensatoren 36, 38 auf die zu erwartenden Schwingungsfrequenzen und Amplituden einstellen.

Im Normalbetrieb (ohne Prüfeinrichtung mit Entkoppelungsinduktivitäten) wird die Eingangsbeschaltung wie gewünscht nicht beeinflusst.

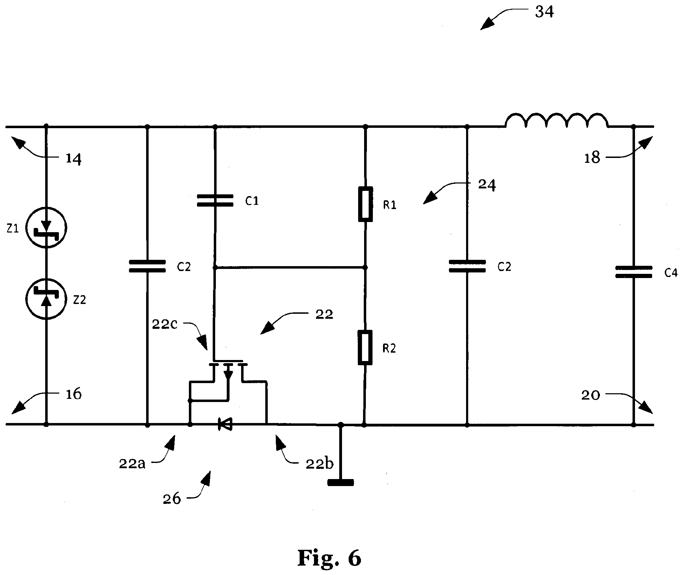

Ferner versteht es sich, dass, wie in Fig. 6 gezeigt, der Verpolungsschutz-MOSFET 22 anstatt zwischen dem ersten Anschluss 14 und dem dritten Anschluss 18 auch zwischen dem zweiten Anschluss 16 und dem vierten Anschluss 20 angeordnet sein könnte. Zudem versteht es sich, dass anstatt des Verpolungsschutz-MOSFETs 22 auch andere Halbleiterelemente, deren Durchgangswiderstand über eine Spannung zwischen zwei Bauelemente-Anschlüssen steuerbar ist, verwendet werden können, wobei die Verwendung von FETs nur eine mögliche Ausgestaltung der erfindungsgemäßen Lehre ist.

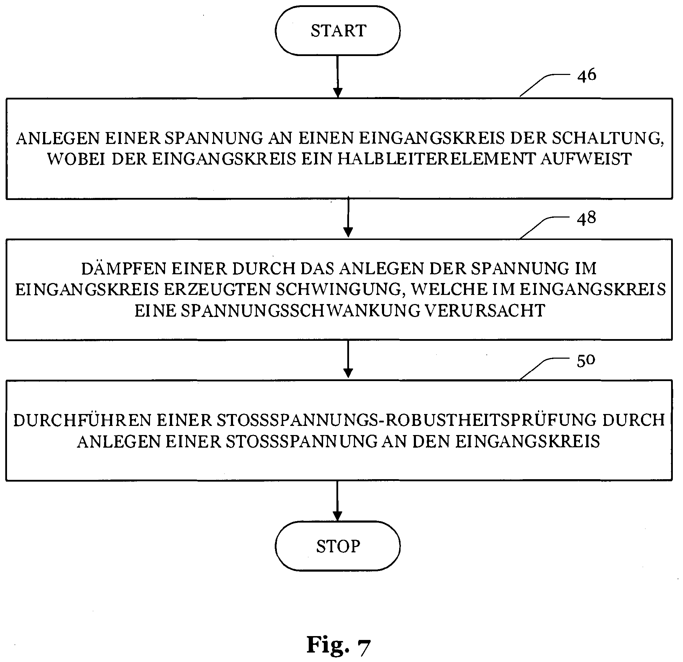

Fig. 7 zeigt ein Flussdiagramm eines Verfahrens zur Prüfung einer Schaltung auf Robustheit gegen Stoßspannungen. Das Verfahren beginnt mit einem Schritt 46 des Anlegens einer Spannung an den Eingangskreis 34 der Schaltung. Das Anlegen der Spannung umfasst bspw., wie in Fig. 5 gezeigt, ein Erhöhen der Spannung zwischen dem ersten Anschluss 14 und dem zweiten Anschluss 16 von o V auf einen vorbestimmten Nominalwert (z. B. 24 V).

Das Verfahren wird mit einem Schritt 48 des Dämpfens einer durch das Anlegen der Spannung im Eingangskreis 34 erzeugten Schwingung, welche im Eingangskreis 34 eine Spannungsschwankung verursacht, fortgesetzt. Wie in Zusammenhang mit Fig. 3 und 5 ausgeführt, dient die Dämpfung der Vermeidung eines Abfalls der Eingangsspannung 30 unter eine Unterspannungsabschaltungsschwelle eines dem Eingangskreis 34 nachgeschalteten Geräts (bspw. eines Gleichspannungswandlers) sowie der Vermeidung des Erreichens der Eingangsschutzdiodenspannung.

Die Dämpfung umfasst insbesondere das temporäre Erhöhen des Durchgangswiderstands eines im Eingangskreis 34 angeordneten Halbleiterelements, wenn die Eingangsspannung 30 abfällt, bspw. indem dafür gesorgt wird, dass der Abfall der Gate-Source-Spannung gegenüber der in Fig. 2 gezeigten Schaltung 12 beschleunigt wird, so dass die Source-Drain-Strecke bei einem Abfallen des Source-Potenzials 40 hochohmig wird.

Das Verfahren schließt mit den Schritt 50 des Durchführens einer Stoßspannungs-Robustheitsprüfung durch Anlegen einer Stoßspannung an den Eingangskreis 34.

### BEZUGSZEICHENLISTE

- 10: Stoßspannungs-Generator
- 12: Eingangskreis
- 14: Anschluss
- 16: Anschluss
- 18: Anschluss
- 20: Anschluss
- 22: Halbleiterelement, FET, Verpolungsschutz-MOSFET
- 24: Spannungsteilerschaltung
- 26: Diode
- 28: Eingangsspannung Eingangskreis
- 30: Ausgangsspannung Eingangskreis
- 32: Ausgangsspannung Gleichspannungswandler
- 34: Modifizierter Eingangskreis
- 36: Kondensator
- 38: Kondensator
- 40: Source-Potenzial
- 42: Gate-Potenzials
- 44: Source-Gate-Spannung
- 46: Prozessschritt
- 48: Prozessschritt
- 50: Prozessschritt

## Patentansprüche

1. Schaltung, umfassend:
einen Gleichspannungswandler; und
einen dem Gleichspannungswandler vorgeschalteten Eingangskreis (34), welcher einen ersten Anschluss (14) und einen zweiten Anschluss (16) zum Anschluss an eine Spannungsversorgung und einen dritten Anschluss (18) und einen vierten Anschluss (20) zum Anschluss an den Gleichspannungswandler aufweist;
wobei der Eingangskreis (34) zwischen dem ersten Anschluss (14) und dem dritten Anschluss (18) ein Halbleiterelement (22) aufweist, wobei ein erster Bauelemente-Anschluss (22c) des Halbleiterelements (22) zumindest über einen ersten Kondensator (36) und einen zweiten Kondensator (38) an einen zweiten Bauelemente-Anschluss (22a) des Halbleiterelements (22) angeschlossen ist, wobei der Eingangskreis (34) weiterhin aufweist:
Mittel zum Steuern eines Durchgangswiderstands des Halbleiterelements (22) über eine Spannung zwischen dem ersten Bauelemente-Anschluss (22c) und dem zweiten Bauelemente-Anschluss (22a);
Mittel zum Dämpfen (48) einer durch das Anlegen einer Spannung (28) im Eingangskreis (34) erzeugten Schwingung, welche bei einer Prüfung der Schaltung auf Robustheit gegen Stoßspannungen im Eingangskreis (34) entsteht und eine Spannungsschwankung verursacht, wobei das Dämpfen ein durch die Spannungsschwankung gesteuertes Erhöhen des Durchgangswiderstands des Halbleiterelements (22) umfasst;
**dadurch gekennzeichnet, dass**
der Eingangskreis eingerichtet ist, die Spannungsschwankung durch temporäres Erhöhen des Durchgangswiderstands in einer negativen Halbwelle der Schwingung zu dämpfen.

2. Schaltung nach Anspruch 1, wobei das Halbleiterelement (22) als Feldeffekttransistor, FET, und vorzugsweise als Verpolungsschutz-Halbleiterschalter ausgebildet ist.

3. Schaltung nach Anspruch 2, wobei
ein Gate-Anschluss (22c) des FETs (22) an einen ersten Bauelemente-Anschluss des ersten Kondensators (36) angeschlossen ist und über einen Widerstand (R1) einer zum ersten Kondensator (36) parallel geschalteten Spannungsteilerschaltung (24) mit dem Source-Anschluss (22a) des FETs (22) verbunden ist;
ein zweiter Bauelemente-Anschluss des ersten Kondensators (36) und ein zweiter Bauelemente-Anschluss eines zweiten Kondensators (38) an dem zweiten Anschluss angeschlossen sind; und
ein Source-Anschluss des FETs (22) an einen ersten Bauelemente-Anschluss des zweiten Kondensators (38) angeschlossen ist.

4. Schaltung nach Anspruch 2 oder 3, wobei der FET (22) als Metall-Oxid-Halbleiter-Feldeffekttransistor, MOSFET, ausgebildet ist.

5. System, umfassend:
eine Schaltung nach einem der Ansprüche 1 bis 4; und
einen Stoßspannungs-Generator (10), welcher Entkopplungs-Induktivitäten aufweist; wobei
der erste Anschluss (14) an einem ersten Pol des Stoßspannungs-Generators (10) und der zweite Anschluss (16) an einem zweiten Pol des Stoßspannungs-Generators (10) angeschlossen ist.

6. System nach Anspruch 5, wobei der erste Kondensator (36) und der zweite Kondensator (38) ausgebildet sind, eine durch Anlegen einer Spannung an den Gleichspannungswandler erzeugte Schwingung in einem die Entkopplungs-Induktivitäten umfassenden Schwingkreis durch spannungsschwankungsabhängiges Erhöhen eines Widerstands des Halbleiterelements (22) zu dämpfen, wobei die Dämpfung ausgelegt ist, eine Unterspannungsabschaltung des Gleichspannungswandlers und/oder eine Überlast an einer Eingangsschutzdiode zu vermeiden.

7. Verfahren zur Prüfung einer Schaltung nach Anspruch 1 auf Robustheit gegen Stoßspannungen, umfassend:
Anlegen (46) einer Spannung (28) an einen Eingangskreis (34) der Schaltung, wobei der Eingangskreis (34) ein Halbleiterelement (22) aufweist; und
Dämpfen (48) einer durch das Anlegen der Spannung (28) im Eingangskreis (34) erzeugten Schwingung, welche im Eingangskreis (34) eine Spannungsschwankung verursacht;
wobei das Dämpfen ein durch die Spannungsschwankung gesteuertes Erhöhen eines Widerstandes des Halbleiterelements (22) umfasst;
**dadurch gekennzeichnet, dass**
die Spannungsschwankung durch temporäres Erhöhen des Durchgangswiderstands in einer negativen Halbwelle der Schwingung gedämpft wird.

8. Verfahren nach Anspruch 7, wobei das Halbleiterelement (22) als Feldeffekttransistor, FET, und vorzugsweise als Verpolungsschutz-Halbleiterschalter ausgebildet ist.

9. Verfahren nach Anspruch 8, wobei das durch die Spannungsschwankung gesteuerte Erhöhen des Widerstandes ein spannungsschwankungsabhängiges Reduzieren einer am FET (22) anliegenden Gate-Source-Spannung umfasst.

10. Verfahren nach Anspruch 9, wobei
ein Drain-Anschluss (22b) des FETs (22) an einen ersten Pol einer Spannungsquelle angeschlossen ist; und
ein Gate-Anschluss (22c) des FETs (22) über einen Kondensator (36) mit einem zweiten Pol der Spannungsquelle verbunden ist;
wobei eine zeitliche Beschleunigung des Abfallens des Gate-Potenzials (42) durch ein Entladen des Kondensators (36) über einen Widerstand (R1)bewirkt wird.

## Claims

1. Circuit, comprising:
a DC-to-DC converter; and
an input circuit (34), which is connected upstream of the DC-to-DC converter and has a first connection (14) and a second connection (16) for connection to a voltage supply, and a third connection (18) and a fourth connection (20) for connection to the DC-to-DC converter;
wherein the input circuit (34) has a semiconductor element (22) between the first connection (14) and the third connection (18), wherein a first component connection (22c) of the semiconductor element (22) is connected at least via a first capacitor (36) and a second capacitor (38) to a second component connection (22a) of the semiconductor element (22), wherein the input circuit (34) furthermore has:
means for controlling an on-state resistance of the semiconductor element (22) by means of a voltage between the first component connection (22c) and the second component connection (22a);
means for damping (48) an oscillation produced in the input circuit (34) by the application of a voltage (28), which oscillation arises during testing of the circuit for robustness against surge voltages in the input circuit (34) and causes a voltage fluctuation, wherein the damping comprises an increase, controlled by the voltage fluctuation, in the on-state resistance of the semiconductor element (22);
**characterized in that**
the input circuit is designed to damp the voltage fluctuation by means of a temporary increase in the on-state resistance in a negative half-cycle of the oscillation.

2. Circuit according to Claim 1, wherein the semiconductor element (22) is in the form of a field-effect transistor, FET, and preferably in the form of a semiconductor switch for protection against polarity reversal.

3. Circuit according to Claim 2, wherein
a gate connection (22c) of the FET (22) is connected to a first component connection of the first capacitor (36) and, via a resistor (R1) of a voltage divider circuit (24) that is connected in parallel with the first capacitor (36), to the source connection (22a) of the FET (22);
a second component connection of the first capacitor (36) and a second component connection of a second capacitor (38) are connected to the second connection; and
a source connection of the FET (22) is connected to a first component connection of the second capacitor (38) .

4. Circuit according to Claim 2 or 3, wherein the FET (22) is in the form of a metal-oxide-semiconductor field-effect transistor, MOSFET.

5. System, comprising:
a circuit according to one of Claims 1 to 4; and
a surge voltage generator (10), which has decoupling inductors; wherein
the first connection (14) is connected to a first pole of the surge voltage generator (10) and the second connection (16) is connected to a second pole of the surge voltage generator (10).

6. System according to Claim 5, wherein the first capacitor (36) and the second capacitor (38) are designed to damp an oscillation produced by application of a voltage to the DC-to-DC converter in a resonant circuit comprising the decoupling inductors by means of a voltage-fluctuation-dependent increase in a resistance of the semiconductor element (22), wherein the damping is designed to prevent an undervoltage cut-off of the DC-to-DC converter and/or an overload at an input protection diode.

7. Method for testing a circuit according to Claim 1 for robustness against surge voltages, comprising:
applying (46) a voltage (28) to an input circuit (34) of the circuit, wherein the input circuit (34) has a semiconductor element (22); and
damping (48) an oscillation which is produced in the input circuit (34) by the application of the voltage (28) and causes a voltage fluctuation in the input circuit (34);
wherein the damping comprises an increase, controlled by the voltage fluctuation, in a resistance of the semiconductor element (22);
**characterized in that**
the voltage fluctuation is damped by means of a temporary increase in the on-state resistance in a negative half-cycle of the oscillation.

8. Method according to Claim 7, wherein the semiconductor element (22) is in the form of a field-effect transistor, FET, and preferably in the form of a semiconductor switch for protection against polarity reversal.

9. Method according to Claim 8, wherein the increase in the resistance, which increase is controlled by the voltage fluctuation, comprises a voltage-fluctuation-dependent reduction in a gate-source voltage present at the FET (22).

10. Method according to Claim 9, wherein
a drain connection (22b) of the FET (22) is connected to a first pole of a voltage source; and a gate connection (22c) of the FET (22) is connected to a second pole of the voltage source via a capacitor (36);
wherein a temporal acceleration of the drop in the gate potential (42) is brought about by the discharging of the capacitor (36) via a resistor (R1).

## Revendications

1. Circuit, comprenant :
un convertisseur de courant continu ; et
un circuit d'entrée (34) connecté en amont du convertisseur de courant continu et qui présente une première borne (14) et une deuxième borne (16) pour la connexion à une tension d'alimentation et une troisième borne (18) et une quatrième borne (20) pour la connexion au convertisseur de courant continu ;
le circuit d'entrée (34) présentant entre la première borne (14) et la troisième borne (18) un élément semi-conducteur (22), une première borne de composant (22c) de l'élément semi-conducteur (22) étant connectée au moins par l'intermédiaire d'un premier condensateur (36) et d'un deuxième condensateur (38) à une deuxième borne de composant (22a) de l'élément semi-conducteur (22),
le circuit d'entrée (34) présentant en outre :
des moyens pour commander une résistance de contact de l'élément semi-conducteur (22) par l'intermédiaire d'une tension entre la première borne de composant (22c) et la deuxième borne de composant (22a) ;
des moyens pour atténuer (48) une oscillation produite par l'application d'une tension (28) dans le circuit d'entrée (34) et qui apparaît lors d'un contrôle du circuit quant à sa résistance aux tensions de choc dans le circuit d'entrée (34) et provoque une variation de tension, l'atténuation comprenant une augmentation de la résistance de contact de l'élément semi-conducteur (22), commandée par la variation de tension ;
**caractérisé en ce que** le circuit d'entrée est aménagé pour atténuer la variation de tension par une augmentation temporaire de la résistance de contact dans une demi-onde négative de l'oscillation.

2. Circuit selon la revendication 1, dans lequel l'élément semi-conducteur (22) est réalisé sous forme de transistor à effet de champ, FET, et de préférence sous forme d'interrupteur à semi-conducteur de protection contre l'inversion de polarité.

3. Circuit selon la revendication 2, dans lequel
une borne de grille (22c) du FET (22) est connectée à une première borne de composant du premier condensateur (36) et est reliée à la borne source (22a) du FET (22) par l'intermédiaire d'une résistance (R₁) d'un circuit diviseur de tension (24) connecté en parallèle au premier condensateur (36) ;
une deuxième borne de composant du premier condensateur (36) et une deuxième borne de composant d'un deuxième condensateur (38) sont connectées à la deuxième borne ; et
une borne de source du FET (22) est connectée à une première borne de composant du deuxième condensateur (38).

4. Circuit selon la revendication 2 ou 3, le FET (22) étant réalisé sous la forme d'un transistor à effet de champ à grille métal-oxyde, MOSFET.

5. Système, comprenant :
un circuit selon l'une quelconque des revendications 1 à 4 ; et
un générateur de tension de choc (10) qui présente des inductances de découplage ; dans lequel
la première borne (14) est connectée à un premier pôle du générateur de tension de choc (10) et la deuxième borne (16) est connectée à un deuxième pôle du générateur de tension de choc (10).

6. Système selon la revendication 5, le premier condensateur (36) et le deuxième condensateur (38) étant réalisés pour atténuer une oscillation produite par l'application d'une tension au convertisseur de courant continu dans un circuit oscillant comprenant les inductances de découplage par une augmentation en fonction de la variation de tension d'une résistance de l'élément semi-conducteur (22), l'atténuation étant conçue pour éviter une coupure à minimum de tension du convertisseur de courant continu et/ou une surcharge au niveau d'une diode de protection d'entrée.

7. Procédé de contrôle d'un circuit selon la revendication 1 quant à sa résistance aux tensions de choc, comprenant les étapes consistant à :
appliquer (46) une tension (28) à un circuit d'entrée (34) du circuit, le circuit d'entrée (34) présentant un élément semi-conducteur (22) ; et
atténuer (48) une oscillation produite par l'application de la tension (28) dans le circuit d'entrée (34) et qui provoque une variation de tension dans le circuit d'entrée (34) ;
l'atténuation comprenant une augmentation d'une résistance de l'élément semi-conducteur (22), commandée par la variation de tension ;
**caractérisé en ce que**
la variation de tension est atténuée par une augmentation temporaire de la résistance de contact dans une demi-onde négative de l'oscillation.

8. Procédé selon la revendication 7, dans lequel l'élément semi-conducteur (22) est réalisé sous forme de transistor à effet de champ, FET, et de préférence sous forme d'interrupteur à semi-conducteur de protection contre l'inversion de polarité.

9. Procédé selon la revendication 8, dans lequel l'augmentation de la résistance, commandée par la variation de tension, comprend une réduction d'une tension grille-source appliquée au FET (22) en fonction de la variation de tension.

10. Procédé selon la revendication 9, dans lequel
une borne de drain (22b) du FET (22) est connectée à un premier pôle d'une source de tension ; et
une borne de grille (22c) du FET (22) est reliée à un deuxième pôle de la source de tension par l'intermédiaire d'un condensateur (36) ;
une accélération dans le temps de la chute du potentiel de grille (42) est provoquée par une décharge du condensateur (36) par l'intermédiaire d'une résistance (R₁).
